# EUROPÄISCHE PATENTANMELDUNG

(11) **EP 1 614 763 A1**
(43) Veröffentlichungstag der Anmeldung: **11.01.2006**
(21) Anmeldenummer: 05013748.8
(22) Anmeldetag: 25.06.2005
(51) Int. Cl.: C23C 4/10

(54) **Verfahren zur Herstellung eines Titan-Suboxid-basierten Beschichtungswerkstoff, entsprechend hergestellter Beschichtungswerkstoff und damit versehenes Sputtertarget**

(30) Priorität: 06.07.2004 DE 102004032635
(71) Anmelder: GfE Metalle und Materialien GmbH, 90431 Nürnberg (DE); Sulzer Metco Coatings GmbH, 38223 Salzgitter (DE)
(72) Erfinder: van Osten, Karl-Uwe, Dipl.-Ing., 90584 Allersberg (DE); Dietrich, Klaus, Dipl.-Ing., 90429 Nürnberg (DE); Schäff, Wolfgang, Dr.-Ing., 91052 Erlangen (DE); Rix, Ricarda, Dipl.-Ing., 90408 Nürnberg (DE); Jansen, Franz, Dr. rer. nat., 52499 Baesweiler (DE)
(74) Vertreter: Hübner, Gerd

(57) **Zusammenfassung**

Ein Herstellungsverfahren für einen Titan-Suboxid-basierten Beschichtungswerkstoff weist folgende Verfahrensschritte auf:
- Bereitstellen eines Titan-Suboxid-Basiswerkstoffes und
- Weiterverarbeiten des Titan-Suboxid-Basiswerkstoffes unter oxidierenden Bedingungen zur in-situ-Bildung eines feindispersen TitanDioxid-Anteils in dem keramischen Titan-Suboxid-Basiswerkstoff.

## Beschreibung

Die Erfindung betrifft ein Verfahren zur Herstellung eines Titan-Suboxid-basierten Beschichtungswerkstoffes sowie einen entsprechend danach hergestellten Beschichtungswerkstoff und ein damit versehenes Sputtertarget.

Das technische Gebiet der vorliegenden Erfindung ist in erster Linie die PVD-Beschichtungstechnik, bei der Titan-Dioxid als Beschichtungsmaterial wegen seines hohen Brechungsindex auf breiter Basis eingesetzt wird. Ursprünglich wurde dabei ausgehend von Titan-Metall als Beschichtungswerkstoff über einen reaktiven PVD-Beschichtungsprozess unter Zugabe von Sauerstoff zu den Prozessgasen auf einem zu beschichtenden Substrat eine Titan-Dioxid-Schicht abgeschieden. Problematisch beim Beschichten auf der Basis von Metall-Targets sind jedoch die insbesondere beim vielfach verwendeten DC-Sputterprozess sehr geringen Beschichtungsraten. Dies verzögert in der technischen Anwendung einschlägige Herstellungsprozesse, wie beispielsweise beim Aufbringen von PVD-Schichtsystemen für eine Wärmeschutzverglasung.

Zur Lösung dieser Problematik wurde im Stand der Technik bereits vorgeschlagen, sogenannte Suboxid-Targets auf der Basis von Titan- oder Niob-Suboxiden zu verwenden.

Solche Titan-Suboxide mit der chemischen Formel TiₙO₂ₙ₋₁ mit n>2 werden als Magneli-Phasen bezeichnet. Sie zeigen sehr positive Eigenschaften, was den Einsatz als Beschichtungswerkstoff betrifft, wie beispielsweise hohe Korrosionsresistenz und eine ausgezeichnete elektrische Leitfähigkeit. Aufgrund ihrer chemischen Zusammensetzung können sie die Schichtherstellung im Rahmen der PVD-Beschichtungstechnik stark beschleunigen.

Herstellungsverfahren für solche Titan-Suboxid-basierten Beschichtungswerkstoffe sind aus einer Vielzahl von Druckschriften zum Stand der Technik bekannt, wie beispielsweise der DE 100 00 979 C1, US 6 334 938 B2, US 6 461 686 B1 und der US 6 511 587 B2. Die darin offenbarten Herstellungsverfahren haben gemeinsam, dass zur Herstellung des Titan-Suboxid-basierten Beschichtungswerkstoffes bzw. des Targets für die PVD-Beschichtungstechnik von Titan-Dioxid als Ausgangsmaterial ausgegangen wird, das unter reduzierenden Bedingungen entweder über einen thermischen Spritzprozess oder eine entsprechende Sintertechnologie in ein Titan-Suboxid überführt wird.

Nachteilig dabei ist Tatsache, dass sich in der Stöchiometrie der damit erzeugten Beschichtungswerkstoffe relativ starke Schwankungen ergeben, die wiederum ein inkonstantes Abtragsverhalten des PVD-Beschichtungsmaterials von dem hergestellten Target mit sich bringt. Grund hierfür ist die partiell unterschiedliche elektrische Leitfähigkeit des Beschichtungswerkstoffes bei variierenden stöchiometrischen Zusammensetzungen. Auch ein geringerer Brechungsindex ist als Nachteil zu verzeichnen.

Besonders problematisch ist der Einfluss des jeweiligen Sauerstoffgehaltes des Suboxides auf das Sputterverhalten. Schwankt dieser bedingt durch stöchiometrische Unterschiede in der Suboxid-Zusammensetzung, so ergibt sich hierdurch eine signifikante Verringerung der Sputterrate. Versuche haben ergeben, dass bei mittels reduzierten Titan-Dioxids hergestellten Sputtertargets nur Abtragsraten von etwa 10 nm/min erzielt werden.

Ausgehend von den geschilderten Problemen des Standes der Technik liegt der Erfindung die Aufgabe zugrunde, ein Verfahren zur Herstellung eines Titan-Suboxid-basierten Beschichtungswerkstoffes sowie einen solchen Beschichtungswerkstoff anzugeben, mit dessen Hilfe signifikant hohe Sputterraten des Beschichtungswerkstoffes ohne relevante Einbußen beim Brechungsindex erzielt werden.

Diese Aufgabe wird in verfahrenstechnischer Hinsicht prinzipiell dadurch gelöst, dass entgegen dem Stand der Technik der Titan-Suboxid-basierte Beschichtungswerkstoff ausgehend von einem Titan-Suboxid-Basiswerkstoff unter dessen Weiterverarbeitung unter oxidierenden Bedingungen hergestellt wird. Dabei wird in situ in dem Titan-Suboxid-Basiswerkstoff ein feindisperser Titan-Dioxid-Anteil erzeugt.

Untersuchungen derartig hergestellter Beschichtungswerkstoffe haben gezeigt, dass Anhaftungen von Titan-Dioxid insbesondere in dessen Rutil-Phase einen positiven Einfluss auf die Sputterrate des Beschichtungswerkstoffes und den Brechungsindex der damit hergestellten Beschichtungen ausüben, wenn dieser Titan-Dioxid-Anteil feindispers in einer leitenden Matrix aus elektrisch leitfähigen Suboxiden wie z.B. Ti₃O₅, Ti₄O₇, Ti₅O₉ und Ti₈O₁₅ eingebunden ist. Die elektrische Leitfähigkeit wird damit nicht signifikant beeinträchtigt. Insgesamt zeichnet sich der mit dem erfindungsgemäßen Verfahren hergestellte Titan-Suboxid-basierte Beschichtungswerkstoff durch seinen besonderen Vorteil für das DC-Sputtern aus, nämlich hohe elektrische Leitfähigkeit, hohe Dichte, hohe Sputterrate, gute Reproduzierbarkeit, geringe Zugabe von Sauerstoff als Prozessgas während des Sputters, geringe Vergiftungsneigung des Targetwerkstoffs bei Zugabe von Sauerstoff als Prozessgas, hohe thermische Beständigkeit durch homogenen Schichtaufbau bei der Targetherstellung und hoher erreichbarer Brechungsindex der aus dem Beschichtungswerkstoff hergestellten Beschichtungen.

Als Verfahren für die Weiterverarbeitung des Titan-Suboxid-Basiswerkstoffes bietet sich zwar grundsätzlich ein geeignetes Sinterverfahren beispielsweise zur Herstellung eines Sintergranulat-Beschichtungswerkstoffes an, bevorzugter Maßen wird jedoch der Titan-Suboxid-basierte Beschichtungswerkstoff durch thermisches Spritzen eines Titan-Suboxid-Basiswerkstoffes, vorzugsweise mit Hilfe eines Mehrkathoden-Plasmabrenners unter Sauerstoffzugabe hergestellt. Dabei wird die Rutil-Phase des Titan-Dioxids mit einem Anteil bis maximal 50 Gew.-% in den Titan-Suboxid-basierten Beschichtungswerkstoff durch Oxidierung entsprechender Titan-Suboxid-Basiswerkstoffe eingebaut. Der Rutilgehalt kann über den Spritzabstand gesteuert werden.

Als bevorzugte Phasen haben sich Titan-Suboxide der Formel TiₙO₂₋₁ mit n=3 bis 8 herauskristallisiert.

Weitere Merkmale, Einzelheiten und Vorteile der Erfindung ergeben sich aus dem nachfolgend beschriebenen

### Ausführungsbeispiel:

Die Herstellung eines Titan-Suboxid-basierten Targets geht aus von einem Titan-Suboxid-Basiswerkstoff in Form eines Pulvers mit einer Körnung, welche im Bereich zwischen 10 und 200µm liegen kann. Eine röntgenographische, halbquantitative Bestimmung des Phasengehaltes dieses Materials ergibt beispielsweise folgende Zusammensetzung:
Ti₃O₅ 18 Gew.-%
Ti₄O₇ 26 Gew.-%
Ti₅O₉ 45 Gew.-%
Ti₆O₁₁ 8 Gew.-%
Ti₇O₁₃ 5 Gew.-%
Ti₈O₁₅ 1 Gew.-%

Es konnte beobachtet werden, dass diese Probe relativ gut ausgebildete kristalline Phasen mit sehr geringen amorphen Anteilen enthält. Titan-Dioxid konnte nicht nachgewiesen werden, so dass die Summe der kristallinen Suboxide zu 100 Gew.-% angenommen wurde. Da bei der in der obigen Auflistung wiedergegebenen Quantifizierung der einzelnen Suboxide wegen der Linienüberlagerung im röntgenographischen Messdiagramm und der teilweise geringen Gehalte nur eine annähernde Bestimmung der TiₙO₂ₙ₋₁-Gehalte möglich ist, ergibt sich bei der oben aufgelisteten Näherung eine Anteilssumme von 103 %.

Dieses Titan-Suboxid-Spritzpulver wird mit einem Mehrkathoden-Plasmabrenner - und zwar einem Triplex-II-Brenner - thermisch gespritzt. Bei diesem Triplex-II-Brenner handelt es sich um einen Dreikathodenbrenner, in dem drei stationäre Lichtbögen erzeugt werden. Dies unterscheidet dieses Gerät von anderen Plasmabrennern für das thermische Spritzen, wie konventionelle Ein-Kathoden-Plasmabrennern. Bei letzteren entstehen Turbulenzen im Plasmastrahl, die dazu führen, dass das eingesetzte Pulver ungleichmäßig verarbeitet wird. Die großen zeitlichen und örtlichen Fluktuationen des Einzellichtbogens beeinflussen das Einschmelzverhalten und die Geschwindigkeitsaufnahme der Partikel im Plasmastrahl ungünstig, was sich auch auf die Effizienz des Beschichtungsprozesses auswirkt.

Bei dem thermischen Spritzen mit Hilfe des angegebenen Mehrkathoden-Plasmabrenners, der in den Fachaufsätzen von Barbezat, G.; Landes, K. "Pasmabrenner-Technologien-Triplex: Höhere Produktion bei stabilerem Prozeß" in ,,Sulzer Technical Review" Ausgabe 4/99, Seiten 32 bis 35 und Barbezat, G. ,,Triplex II - Eine neue Ära in der Plasmatechnologie" a.a.O., Ausgabe 1/2002, Seiten 20, 21 näher vorgestellt ist, erfolgt eine gleichmäßige, kontrollierte Behandlung des Titan-Suboxid-Pulvers, was für die Einstellung eines definierten Anteils an Titan-Dioxid in seiner Rutilmodifikation in situ wesentlich ist. Entscheidend ist die Tatsache, dass zum Betrieb des Mehrkathoden-Plasmabrenners das Edelgas Argon oder ein Gemisch der Edelgase Argon und Helium verwendet wird, um eine Reduktion des Titan-Suboxid-Basiswerkstoffes im Brenner zu verhindern und damit seine kontrollierte Oxidation durch die Luftatmosphäre zu ermöglichen. Damit zeichnet sich der so hergestellte Beschichtungswerkstoff durch eine besondere chemische Homogenität aus. Diese besondere Werkstoffbeschaffenheit mit dem erläuterten Anteil an feindispers in einer leitfähigen Titan-Suboxid-Matrix verteilten Rutil führt zu einer deutlich besseren Sputterbarkeit des Beschichtungswerkstoffes im Vergleich zu konventionellen Titan-Metall-Targets.

### Folgende System Parameter wurden beim Plasmaspritzprozess verwendet:

| | |
|---|---|
| Stromstärke: | 450 - 520A |
| Plasmagas Helium: | 25 - 35 SLPM |
| Plasmagas Argon: | 20 - 30 SLPM |
| Spritzabstand: | 80 - 120 mm |
| Auftrag pro Übergang: | 20µm |
| Spritzatmosphäre: | Luft |

Der wie vorstehend erläutert hergestellte Beschichtungswerkstoff in Form einer Titan-Suboxid-basierten Spritzschicht weist folgende Anteilszusammensetzung auf, die wiederum halbquantitativ röntgenographisch ermittelt wurde:
Rutil 41 Gew.-%
Ti₃O₁₅ 15 Gew.-%
Ti₄O₇ 10 Gew.-%
Ti₅O₉ 9 Gew.-%
Ti₆O₁₁ 9 Gew.-%
Ti₇O₁₃ 5 Gew.-%
Ti₈O₁₅ 11 Gew.-%
(Summe der Suboxide 59 Gew.-%)

Zu der vorstehenden Tabelle ist festzuhalten, dass die angegebenen Gehalte der Titan-Suboxid-Phasen halbquantitativ aus den relativen Peakintensitäten der röntgenographischen Messung ermittelt wurden. Es wurden ausschließlich die kristallinen Phasen bestimmt und auf 100 Gew.-% umgerechnet. Eine eindeutige Quantifizierung der Titan-Suboxide ist nicht möglich, da viele Verbindungen mit unterschiedlichem Sauerstoffdefizit vorliegen können.

Zur Verifizierung der Verwendbarkeit eines Titan-Suboxid-basierten Beschichtungswerkstoffes mit feindispersem Rutil-Anteil zum Einsatz in DC-Puls-Magnetron-Sputtern wurden PVD-Beschichtungsversuche gefahren und mit entsprechenden Versuchen auf der Basis herkömmlicher Ti₄O₇₋Mischoxid-Targets verglichen.

Folgende Systemparameter wurden dabei verwendet:
Target-Substrat-Abstand 90 mm
Targetmaterial Titan-Suboxid-Beschichtungswerkstoff mit Rutil bzw. Ti₄O₇-Mischoxid
Gasfluss 2x100sccm/Reinheit 4.8
Carrier-Geschwindigkeit 0,5 mm/s

Als Prozessparameter wurden eingestellt:
Basisdruck ca. 3x10⁻⁶mbar
Substrat-Temperatur: Raumtemperatur
Entladungsleistung 2000 - 6000 W
Generatorfrequenz 100 kHz
Pulszeit 1 µs
Mischgasfluss (Ar: O₂W9:1) 0-100 sccm/Reinheit O₂ 4,5 / Ar 5,0 Totaldruck 500 mPa
Substrat: Floatgläser 10 x 10 cm², 5 x 5 cm²

Der Mischgas-Fluss mit einer O₂-Zugabe ist wegen der Unterstöchiometrie im Beschichtungswerkstoff notwendig. Oberhalb eines bestimmten Sauerstoff-Flusses tritt keine Änderung in der Entladespannung mehr auf, womit das unstetige Verhalten, wie es beim Sputtern von metallischen Targets beim Übergang vom metallischen in den oxidischen Modus üblich ist, entfällt. Mit den erfindungsgemäßen keramischen Suboxid-Targets wird also eine stabilere Prozessführung möglich.

Die folgende Vergleichstabelle für die statische Sputterrate aₛ und des optischen Brechungsindex n für unterschiedliche Titan-Target-Materialien zeigt, dass die erfindungsgemäßen keramischen Titan-Suboxid-basierten Beschichtungswerkstoffe mit Rutil-Phase einen optimalen Kompromiss bezüglich Sputterrate und Brechungsindex ermöglichen. Die TiOₓ₋Spritzschicht zeigt die höchste Sputterrate im Vergleich zu dem Ti₄O₇ - Mischoxid-Target und dem im Transition-Mode reaktiv gesputterten Titan-Target. Lediglich der Brechungsindex für das im Oxid-Mode gesputterte Titan-Target ist höher, allerdings bei einer um den Faktor von fast 12 geringeren Sputterrate.

**Tabelle: Vergleich der statischen Sputterrate aₛ und des optischen Brechungsindex n für unterschiedliche Titan-basierte Targetmaterialien.**

| Material | Rate aₛ bei 1W/cm² [nm/min] | n bei λ= 550 nm |
|---|---|---|
| TiOₓ-Spritzschicht | 14,8 | 2,47 |
| Ti₄O₇-Mischoxid | 9,9 | 2,42 |
| Ti oxide mode | 1,2 | 2,51 |
| Ti transition mode | 6,3 | 2,42 |

## Patentansprüche

1. Verfahren zur Herstellung eines Titan-Suboxid-basierten Beschichtungswerkstoffes,
**gekennzeichnet durch** folgende Verfahrensschritte:
Bereitstellen eines Titan-Suboxid-Basiswerkstoffes und Weiterverarbeiten des Titan-Suboxid-Basiswerkstoffes unter oxidierenden Bedingungen zur in-situ-Bildung eines feindispersen Titan-Dioxid-Anteils in dem keramischen Titan-Suboxid-Basiswerkstoff.

2. Verfahren nach Anspruch 1, **dadurch gekennzeichnet, dass** der Titan-Suboxid-basierte PVD-Beschichtungswerkstoff durch thermisches Spritzen des Titan-Suboxid-Basiswerkstoffes unter Sauerstoffzugabe hergestellt wird.

3. Verfahren nach Anspruch 1, **dadurch gekennzeichnet, dass** der Titan-Suboxid-basierte Beschichtungswerkstoff durch thermisches Spritzen des Titan-Suboxid-Basiswerkstoffes unter Vermeidung von reduzierenden Bedingungen durch die Verwendung von Edelgasen beim Plasmaspritzen in Luftatmosphäre hergestellt wird..

4. Verfahren nach Anspruch 1 oder 2, **dadurch gekennzeichnet, dass** das Titan-Dioxid als Rutil in den Titan-Suboxid-basierten Beschichtungswerkstoff eingebaut wird.

5. Verfahren nach einem der vorgenannten Ansprüche, **dadurch gekennzeichnet, dass** der Anteil an feindispersem Titan-Dioxid in dem Titan-Suboxid-basierten Beschichtungswerkstoff bis maximal 50 Gew.-% beträgt.

6. Verfahren nach einem der vorgenannten Ansprüche, **dadurch gekennzeichnet, dass** als Titan-Suboxid-Basiswerkstoff eine Pulvermischung aus Titan-Suboxiden der Formel TiₙO₂ₙ₋₁ vorzugsweise mit n= 3 bis 8 eingesetzt wird.

7. Verfahren nach Anspruch 2, **dadurch gekennzeichnet, dass** der Titan-Suboxid-Basiswerkstoff mit Hilfe eines Mehrkathoden-Plasmabrenners thermisch gespritzt wird.

8. Beschichtungswerkstoff, insbesondere elektrisch leitfähiger PVD-Beschichtungswerkstoff, hergestellt nach einem der vorgenannten Ansprüche, **gekennzeichnet durch** einen in einem keramischen Titan-Suboxid-Basiswerkstoff feindispers verteilten Titandioxid-Anteil.

9. Beschichtungswerkstoff nach Anspruch 8, **dadurch gekennzeichnet, dass** der Titandioxid-Anteil als Rutil vorliegt.

10. Beschichtungswerkstoff nach Anspruch 8 oder 9, **gekennzeichnet durch** Titan-Suboxide der Formel TiₙO₂ₙ₋₁ vorzugsweise mit n= 3 bis 8 als Titan-Suboxid-Basiswerkstoff.

11. Beschichtungswerkstoff nach einem der Ansprüche 8 bis 10, **dadurch gekennzeichnet, dass** der Anteil an feindispersem Titan-Dioxid in dem Titan-Suboxid-basierten Beschichtungswerkstoff bis maximal 50 Gew.-% beträgt.

12. Beschichtungswerkstoff nach einem der Ansprüche 8 bis 11, **dadurch gekennzeichnet, dass** er als Schmelz- oder Sintergranulat vorliegt.

13. Sputtertarget mit einem Beschichtungswerkstoff nach einem der Ansprüche 8 bis 11 auf einem Substrat.

14. Sputtertarget nach Anspruch 13, **dadurch gekennzeichnet, dass** es als Rohrkathode oder Planartarget ausgebildet ist.
